# EUROPEAN PATENT APPLICATION

(11) **EP 1 480 274 A2**
(43) Date of publication of application: **24.11.2004**
(21) Application number: 04252506.3
(22) Date of filing: 29.04.2004
(51) Int. Cl.: H01L 29/51, H01L 21/8246

(54) **Nonvolatile semiconductor memory device having gate stack including oha film and method of manufacturing the same**

(30) Priority: 30.04.2003 KR 2003027543
(71) Applicant: Samsung Electronics Co., Ltd., Suwon-si, Gyeonggi-do (KR)
(72) Inventor: Chae, Soo-doo, Bundang-gu, Seongnam-si Gyeonggi-do (KR); Lee, Jung-hyun, Yongin-si, Gyeonggi-do (KR); Kim, Chung-woo, Bundang-gu Seongnam-si, Gyeonggi-do (KR); Kim, Moon-kyung 201-1305 Woosung 2-cha Apt, Seoul (KR); Hwang, Hyun-sang Materails Science & Engineering, Buk-gu Kwangju-si (KR)
(74) Representative: Greene, Simon Kenneth

(57) **Abstract**

Provided is a nonvolatile semiconductor memory device including a semiconductor substrate having a source region and a drain region separated by a predetermined distance, and a gate stack formed between the source region and the drain region on the substrate, one end of the gate stack contacting the source region and the other end of the gate stack contacting the drain region, wherein the gate stack include: a tunneling film; a first trapping material film doped with a predetermined first doping impurity having a higher dielectric constant than a nitride film (Si₃N₄); a first insulating film having a higher dielectric constant than a nitride film; and a gate electrode, all of which are deposited sequentially on a substrate. There is provided a nonvolatile semiconductor memory device capable of effectively controlling the trap density according to the doping concentration, thereby increasing the write/erase speed of data at a low operating voltage.

## Description

The present invention relates to a semiconductor memory device, and more particularly, to a nonvolatile semiconductor memory device having a gate with a different film structure from SONOS, and a method of manufacturing the same.

Recent developments of portable data storage device, such as memory sticks, that readily allow data sharing and exchange regardless of hardware type have lead to increased demands to safely store large amount of data. One possibility in this respect is to use a flash memory device, i.e., a special type of EEPROM, which can be erased or programmed in blocks of data and the contents of which are retained even when the power is turned off. The flash memory device is generally structured in the form of a multi-layer comprising a floating gate, where a charge is stored, a transistor gate, where data are stored, and a control gate that controls the floating gate, the gates being sequentially deposited. However, the flash memory has a low retention characteristic and data stored therein cannot be kept safely for long time due to a leakage current.

To solve this problem, a SONOS memory device having a reduced height has been introduced. The SONOS memory device uses stacked layers between a substrate and a control gate. That is, instead of the floating gate and the insulating layers above and below the floating gate in the flash memory, the SONOS memory device uses a stacked layer (ONO) made by sequentially depositing an oxide film, a nitride film, and another oxide film. In addition, the SONOS memory device operates by shifting a threshold voltage when a charge is trapped in the nitride film. A detailed description of the SONOS memory device is disclosed in the article "An Embedded 90nm SONOS Nonvolatile Memory Utilizing Hot Electron Programming and Uniform Tunnel Erase" by C. T. Swift et al. published in the Technical Digest of International Electron Device Meeting (IEDM) December 2002, pp. 927-930.

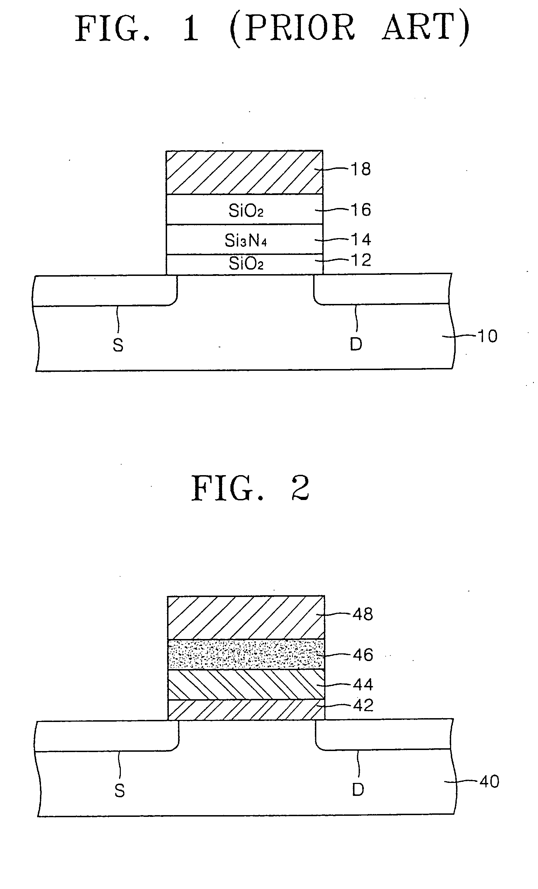

FIG. 1 is a cross-sectional view showing a basic structure of a conventional SONOS memory device.

Referring to FIG. 1, a first silicon oxide (SiO₂) film 12 is formed on a channel region between a source region S and drain region D of a substrate 10. One end of the first silicon oxide film 12 contacts the source region S and the other end of the first silicon oxide film 12 contacts the drain region D. The first silicon oxide film 12 is for tunneling a charge. A nitride (Si₃N₄) film 14 is formed on the first silicon oxide film 12. The nitride film 14, which is practically a material film for storing data, traps the charge tunneled through the first silicon oxide film 12. A second silicon oxide film 16 is formed as a barrier film for blocking the movement of the charge from the nitride film 14 upward through the silicon nitride film 14. A gate electrode 18 is formed on the second silicon oxide film16.

The conventional SONOS device depicted in FIG. 1 has the following drawbacks.

Practically, an operating voltage is very high. If a low operating voltage is applied to the conventional SONOS device, the speed of writing/erasing of data becomes much slower than the specified speed in the specification. Due to such voltage dependence characteristic, the control of a trap density of the silicon nitride film 14 also becomes difficult. The retention time also is not long enough as expected.

These drawbacks are caused by the thick thickness of the films resulted from the low dielectric constants of the nitride film 14 and the first and second oxide films 12 and 16.

Recently, a paper by C. Lee et al., titled "Novel Structure of SiO₂/SiN/High-k dielectric, Al₂O₃ for a SONOS Type Flash Memory" published in Extended Abstract of 2002 International Conf. on Solid State Device and Materials, Nagoya, Japan, Sept. 2002, pp162-163 has been reported that programming, erasing, and retention characteristic of the barrier film have improved by using an aluminum oxide film (Al₂O₃) instead of an silicon oxide film. However, the improvements are quite insignificant, and still the applied voltage is very high and controlling the trap density of the silicon nitride film is difficult.

In accordance with the present invention, there is provided a nonvolatile semiconductor memory device comprising: a substrate having a source region and a drain region separated by a predetermined distance; a gate stack formed between the source region and drain region on the substrate, one end of the gate stack contacting the source region and the other end of the gate stack contacting the drain region, wherein the gate stack comprises: a tunneling film; a first trapping material film doped with a predetermined first doping impurity having a higher dielectric constant than a nitride film (Si₃N₄); a first insulating film having a higher dielectric constant than the silicon nitride film; and a gate electrode, all films of which are deposited sequentially.

The first insulating film may be formed of an aluminum oxide film (Al₂O₃).

According to an embodiment of the present invention, a first oxide film is further formed between the tunneling film and the first trapping material film, and a second oxide film is further formed between the first trapping material film and the first insulating film. The first and second oxide films may be formed of an aluminum oxide (Al₂O₃), and the first insulating film may be a film selected from the group consisting of HfO₂ film, ZrO₂ film, Ta₂O₅film, and TiO₂ film.

The predetermined first impurity may be a lanthanide containing Dy, and the doping concentration is 1∼20%.

The first trapping material film may be a film selected from the group consisting of a HfO₂ film, a ZrO₂ film, a Ta₂O₅ film, a TiO₂ film, and an Al₂O₃ film.

According to another embodiment of the present invention, a second trapping material film doped with a predetermined second doping material and having a higher dielectric constant than the nitride film (Si₃N₄), and a second insulating film having a higher dielectric constant than the nitride film are further formed sequentially between the first insulating film and the gate electrode.

In addition, a first oxide film may be further formed between the tunneling film and the first trapping material film. In this case, a second oxide film may be further formed between the first trapping material film and the first insulating film, a third oxide film may be further formed between the first insulating film and the second trapping material film. Alternatively, a fourth oxide film may be further formed between the second trapping material film and the second insulating film. In other words, the first through the fourth oxide films may be optionally formed if necessary.

The second trapping material film may be a film selected from the group consisting of a HfO₂ film, a ZrO₂ film, a Ta₂O₅ film, a TiO₂ film, and an Al₂O₃ film.

The third and/or the fourth oxide film may be formed of an aluminum oxide film.

The second insulating film may be a film selected from the group consisting of a HfO₂ film, a ZrO₂ film, a Ta₂O₅ film, and a TiO₂ film.

The predetermined second impurity may be a lanthanide containing Dy, and the doping concentration may be in a range of 1∼20%.

In accordance with another aspect of the present invention, there is provided a method of manufacturing a nonvolatile semiconductor memory device, the method comprising: forming a tunneling oxide film, a first trapping material film doped with a first predetermined impurity and having a higher dielectric constant than that of the nitride film, a first insulating film having a higher dielectric constant than that of the nitride film, and a gate electrode, all of which are deposited sequentially on a semiconductor substrate; forming a photosensitive film pattern defining a gate region on the gate electrode; forming a gate stack by sequentially etching the gate electrode, the first insulating film, the first trapping material film, and the tunneling oxide film around the photosensitive film pattern; removing the photo sense film pattern; and forming a source and drain region around the gate stack on the semiconductor substrate.

A nonvolatile memory device according to the present invention provides the capability of controlling trap density effectively according to the doping concentration. Accordingly, writing/erasing of data can be operated at a lower voltage than in the conventional art, thereby increasing the operating speed in comparison with the prior art.

The present invention provides a nonvolatile semiconductor memory device capable of operating satisfactorily at a voltage lower than the operating voltage of a SONOS memory device, operating at a faster speed at the same voltage level as the SONOS memory device, and effectively controlling a trap density of a trapping material layer.

The present invention also provides a method of fabricating the nonvolatile semiconductor memory device.
FIG. 1 is a cross-sectional view of a SONOS memory device as an example of the nonvolatile memory device according to the prior art;
FIGS. 2 through 5 are cross-sectional views of nonvolatile memory devices, according to first through fourth embodiments of the present invention;
FIG. 6 is a graph showing the characteristics of a leakage current according to a doping concentration of an insulating film having a high dielectric constant, used for a nonvolatile memory device according to the embodiment of the present invention;
FIG. 7 is a graph showing a variation of a leakage current and an effective thickness according to a doping concentration of an insulating layer having a high conductivity, used for a nonvolatile memory device, according to an embodiment of the present invention;
FIG. 8 is a graph showing a variation of a flat band voltage according to a stress charge, according to an embodiment of the present invention;
FIG. 9 is a graph showing a variation of a flat band voltage according to a write/read time, according to an embodiment of the present invention;
FIG. 10 is a graph showing a variation of a flat band voltage according to a retention time, according to an embodiment of the present invention;
FIG. 11 is a graph showing a variation of a flat band voltage according to a programming time, according to an embodiment of the present invention;
FIG. 12 is a graph showing a variation of a flat band voltage according to a erasing time, according to an embodiment of the present invention; and
FIG. 13 is a graph showing an energy band of an OHA film according to an embodiment of the present invention and an energy band of an ONO film according to the conventional nonvolatile memory device.

Hereinafter, a nonvolatile semiconductor memory device in accordance with embodiments of the present invention will be described more fully with reference to the accompanying drawings. To facilitate understanding, the thickness of the films and regions in the drawings are exaggerated for clear explanation.

### 〈First embodiment〉

Referring to FIG. 2, a source region S and drain region D are formed separated by a predetermined distance on a substrate 10. A space between the source region S and the drain region D on the substrate 10 defines a channel region. A gate stack is formed on the channel region. The gate stack, formed of layers deposited sequentially, comprises: a tunneling oxide film 42, one end of the tunneling oxide film 42 contacting the source region S and the other end of the tunneling oxide film 42 contacting the drain region D; a first trapping material layer 44: a first insulating film 46 having a high dielectric constant; and a gate electrode 48. The tunneling oxide film 42 is a silicon oxide film. The thickness of the tunneling oxide film 42 is approximately 1.5 ∼ 4 nm. When a predetermined voltage is applied to the gate electrode 48 and the drain region D, a charge, that is, electrons that passed through the tunneling oxide film 42 are trapped by the first trapping material film 44. Preferably, the first trapping material film 44 is formed of a non-nitride film, but an insulating film having a high dielectric constant, doped with a predetermined impurity can also be used. Also, preferably, the insulating film is formed of an oxide film having a high dielectric constant selected from the group consisting of HfO₂, ZrO₂, Ta₂O₅, TiO₂, and Al₂O₃, more preferably, it is formed of HfO₂ film. When the first trapping material film is an HfO₂ film, its thickness may be approximately 2 ∼ 15 nm.

While, the predetermined impurity doped on the first trapping material film 44 is preferably formed of a lanthanide, such as, a material selected from the group consisting of La, Ce, Pr, Nd, Sm, Eu, Gd, Tb, Dy, Ho, Er, Tm, Yb, and Lu, more preferably, it is formed of Dy. A doping concentration in this case is approximately 1 ∼ 20%, preferably 10%.

Next, the first insulating film 46 which has a high dielectric constant is formed to prevent a portion of the electrons from moving through the first trapping material film 44 to the gate electrode 48 while the charge is being trapped by the first trapping material film 44. Preferably, the first insulating film 46 is formed of an aluminum oxide (Al₂O₃). Other materials having the same dielectric constant as the aluminum oxide may be used for the first insulating film 46. The gate electrode 48 is preferably formed of a polysilicon electrode doped with a conductive impurity. Alternatively, other electrodes, such as a tungsten silicide electrode, may be used for the gate electrode 48.

### 〈Second embodiment〉

This embodiment is related to a nonvolatile semiconductor memory device having a diffusion barrier layer on and under the first trapping material film 44.

In the following, the same reference numerals as in the first embodiment describe the same elements.

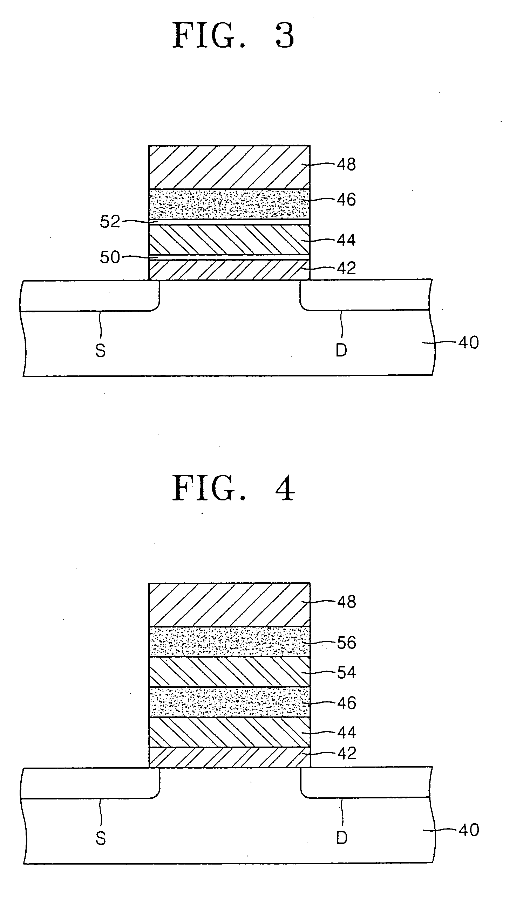

Referring to FIG. 3, a first oxide film 50 as a first diffusion barrier layer is formed between the tunneling oxide film 42 and the first trapping material film 44. The first oxide film 50 is aluminum oxide film. The thickness of the tunneling oxide film 42 is approximately 1∼4 nm, and that of the first oxide film 50 is approximately 0.5∼2 nm. It is considered that a tunneling film is an united form of the tunneling oxide film 42 and the first oxide film 50.

A second oxide film 52 as a second diffusion barrier layer is formed between the first trapping material film 44 and the first insulating film 46. The second oxide film 52 is an aluminum oxide film, and the first insulating film 46 is an insulating film having a high dielectric constant, for example, selected from the group consisting of HfO₂, ZrO₂, Ta₂O₅, and TiO₂. The thickness of the second oxide film 52 is approximately 0.5∼2 nm, and the thickness of the first insulating film 46 is approximately 3∼20 nm.

As in the first embodiment, the nonvolatile semiconductor memory device according to the second embodiment includes a film formed between the first insulating film 46 and the gate electrode 48 with a thickness of 3∼20 nm of a metal oxide selected from the group consisting of HfO₂, ZrO₂, Ta₂O₅, and TiO₂ after forming the first insulating film 46 as thin as the second oxide film 52.

In this embodiment, the first and second oxide films 50 and 52 are both formed of aluminum oxide films. However, any material that can act as a diffusion barrier layer can replace either the first oxide film 50 or the second oxide film 52. Further, any material that can act as a diffusion barrier layer can replace both the first oxide film 50 and the second oxide film 52. Also, any material that can act as a diffusion barrier layer can replace other insulating films other than the oxide film.

### 〈Third embodiment〉

This embodiment is related to a nonvolatile semiconductor memory device comprising a gate stack formed on a channel region of a substrate 10 and having a plurality of trapping material films.

Referring to FIG. 4, a first trapping material film 44 and a first insulating film 46 are formed on the tunneling oxide film 42. A second trapping material film 54 and a second insulating film 56 are sequentially deposited on the first insulating film 46. A gate electrode 48 is formed on the second insulating film 56. Preferably, the second trapping material film 54 is formed of an insulating film doped with a lanthanide having a high dielectric constant as the same material as the first trapping material film 44. Alternatively, the second trapping material film 54 may be formed of other insulating films. Likewise, the second insulating film 56 is preferably formed of the same insulating material film as the first insulating film46. Alternatively, the second insulating film 56 may be formed of other insulating films. Also, the second trapping material film 54 and the second insulating film 56 have the same thickness as or a different thickness from the first trapping material film 44 and the first insulating film, respectively.

### 〈Fourth embodiment〉

This embodiment is related to a nonvolatile semiconductor memory device further comprising a diffusion barrier layer.

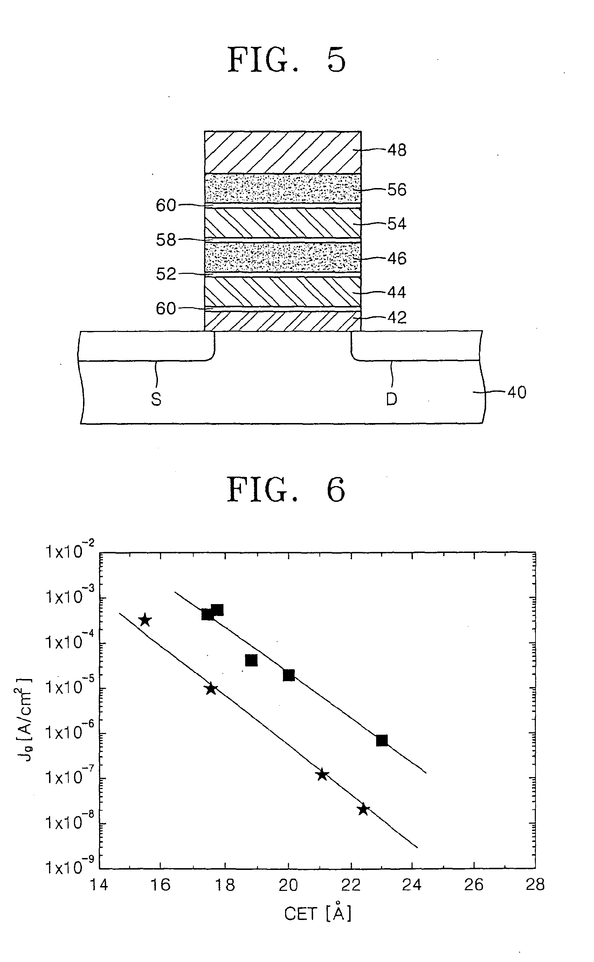

More specifically, as shown in FIG. 5, a first oxide film 50 is formed between the tunneling oxide film 42 and the first trapping material film 44, the second oxide film 52 is formed between the first trapping material film 44 and the first insulating film 46, and in addition to these films, a third oxide film 58 is formed between the first insulating film 46 and the second trapping material film 54, and a fourth oxide film is formed between the second trapping material film 54 and the second insulating film 56. The third and the fourth oxide films 58 and 60 are diffusion barrier layers as the first and second oxide films 50 and 52, and they are preferably formed of aluminum oxide films, but they could be other oxide film or an insulating film.

According to the above descriptions, for a nonvolatile semiconductor device according the embodiments of the present invention, the first and second trapping material films 44 and 54 of the gate stack are formed of an insulating film, such as HfO₂ film doped with a lanthanide having a high dielectric constant, for example, Dy, with a predetermined ratio.

In the following, the results of an experiment performed for verifying the characteristics of the nonvolatile semiconductor memory device according to the first embodiment of the present invention will be described.

A leakage current density in two cases, that is, cases where the first trapping material film 44 is formed of HfO₂ film without doping (hereinafter, a first case) and with doping with a predetermined concentration of Dy (hereinafter, a second case), were measured.

FIG. 6 is a graph showing the results of the experiment. Symbol "■" refers to a variation of the leakage current density in the first case, and symbol "□" refers to that in the second case. Referring to FIG. 6, the leakage current density (Jg) in the second case is much lower than that in the first case at the same effective thickness (□).

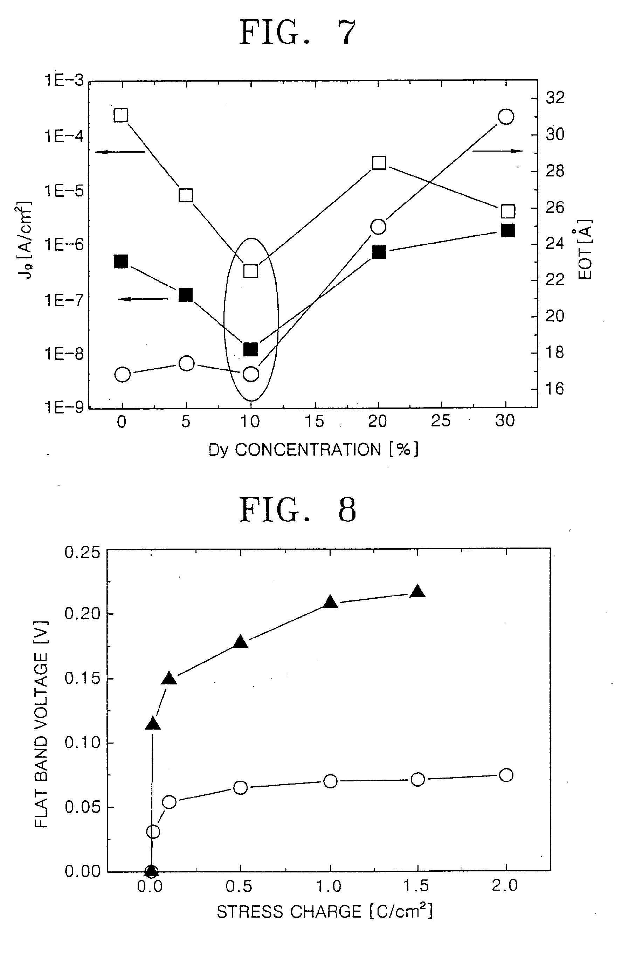

FIG. 7 shows a variation of the leakage current density (Jg) and the effective thickness according to the concentration (%) of Dy in the second case. The leakage current density (Jg) and the effective thickness were measured by AES. In FIG. 7, a graph with symbol "□" shows the variation of the leakage current density when 2V of flat band voltage was applied (hereinafter, a first graph), a graph with symbol **"■"** refers to the variation of the leakage current density when 1V of flat band voltage was applied (hereinafter, a second graph), and a graph with symbol "o" refers to the variation of the effective thickness (hereinafter, a third graph).

Referring to the first through third graphs in FIG. 7, a lowest leakage current density and the thinnest effective thickness are shown at the Dy concentration of approximately 10%. That is, at the Dy concentration of approximately 10%, the characteristics of leakage current and the effective thickness have optimum values.

Next, in order to verify the effects of doping with Dy on the charge trap, the variation of the flat band voltage under an electrical stress with respect to the above two cases was measured, and the FIG. 8 shows the experimental results.

In FIG. 8, a graph with symbol "o" shows the results from the first case (hereinafter, a fourth graph), and a graph with symbol "▲" shows the second case (hereinafter, a fifth graph).

Referring to the fourth and fifth graphs in FIG. 8, it is seen that as the stress charge increases, that is, by increasing the concentration of Dy to be doped on the first trapping material film 44, the differences in the flat band voltage between the two cases increases drastically.

Since the flat band voltage is directly related to the trapped charge in the first trapping material film 44, it can be said from this result that the trapping density of the first trapping material film 44 is higher in the second case than that in the first case.

According to the foregoing descriptions, for a nonvolatile semiconductor memory device, since the trapping material film is formed of an insulating film doped with a lanthanide having a high dielectric constant, the effective thickness of the trapping material film can be made thin, and the trap density of the trapping material film can be easily controlled by controlling the doping concentration.

Consequently, in comparison with the prior art, a nonvolatile semiconductor memory device according to the present invention can be operated at a lower voltage, and the retention time also can be extended.

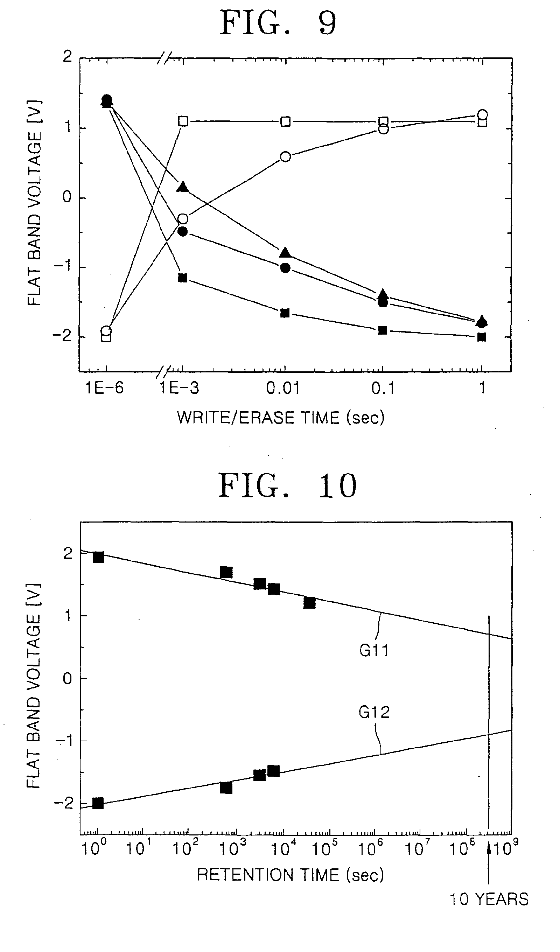

FIG. 9 and FIG. 10 show experimental results of writing/erasing time and retention time versus the flat band voltage, respectively. In FIG. 9, graphs with symbols "o" and ""□" show the variation of the flat band voltage according to the applying time of voltage when applied voltages for recording data is 7 volts and 8 volts, respectively, (hereinafter, a sixth graph and seventh graph, respectively), and graphs with symbols "▲", "●", and **"■"** show the variation of the flat band voltage according to the applying time of voltage when applied voltages for erasing data is 6 volts, 7 volts, and 8 volts, respectively, (hereinafter, a eighth graph through tenth graph, respectively).

Referring to the sixth and seventh graphs in FIG. 9, it is seen that the time to reach to the desired flat band voltage is very short even in the case where the applied voltage is 8 volts, which is lower relative to the voltage in the prior art (about 10 volts) applied to the gate electrode for data writing, that is, for charge trap. When the applied voltage to the gate electrode is 7 volts, the shift of the flat band voltage is slower than that when the applied voltage is 8 volts, however, taking into consideration that the magnitude of the flat band voltage required for identifying "1" and "0" is 0.5 volt, the time for shifting from initial value to 0.5 volt is also very short when the voltage applied to the gate electrode is 7 volts. This means that even at a lower voltage, data writing is faster relative to the voltage of the prior art.

Referring to the graphs 8 through 10 in FIG. 9, in the cases that the absolute value of voltages applied to the gate electrode for data erasing are smaller (-8 volts, -7 volts, or -6 volts) than the voltages in the prior art, it is seen that even there are some relative differences, but generally, the flat band voltage decreases drastically. This means that the speed of data erasing become faster.

Next, referring to FIG. 10, graph G11 shows the variation of the flat band voltage according to the retention time for keeping data"1" in a normal state when a predetermined gate voltage Vg (Vg=8 volts) was applied to the gate electrode 48, and a charge was trapped in the first trapping material film 44 by applying a predetermined voltage Vd to the drain region D, that is, data "1" was recorded in the first trapping material film 44. Graph G12 shows the variation in the flat band voltage according to the retention time for keeping the data "0" when all charges in the first trapping material film 44 were removed, that is, recorded "0" in the first trapping material film 44 by applying an erasing voltage (-8 volts) to the gate electrode 48.

For a clear distinction between recorded data of "1" and "0" after a long time, it is preferable that the voltage difference between the flat band voltage corresponding to the data "1"( hereinafter, a first flat band voltage) and that of corresponding to the data "0"(hereinafter, a second flat band voltage) is more than a predetermined value, such as 0.5 volt. Referring to the graphs G11 and G12 in FIG. 10, it is seen that the voltage difference between the first and second flat band voltages at a time corresponding to 10 years after recording the data is more than 0.5 volt. That is, a nonvolatile semiconductor memory device according to the present invention is capable of operating at a lower voltage than in the conventional art. In spite of operating at a lower voltage, it can be said that the characteristics of retention time and the data writing/erasing time are improved relative to the same times in the prior art.

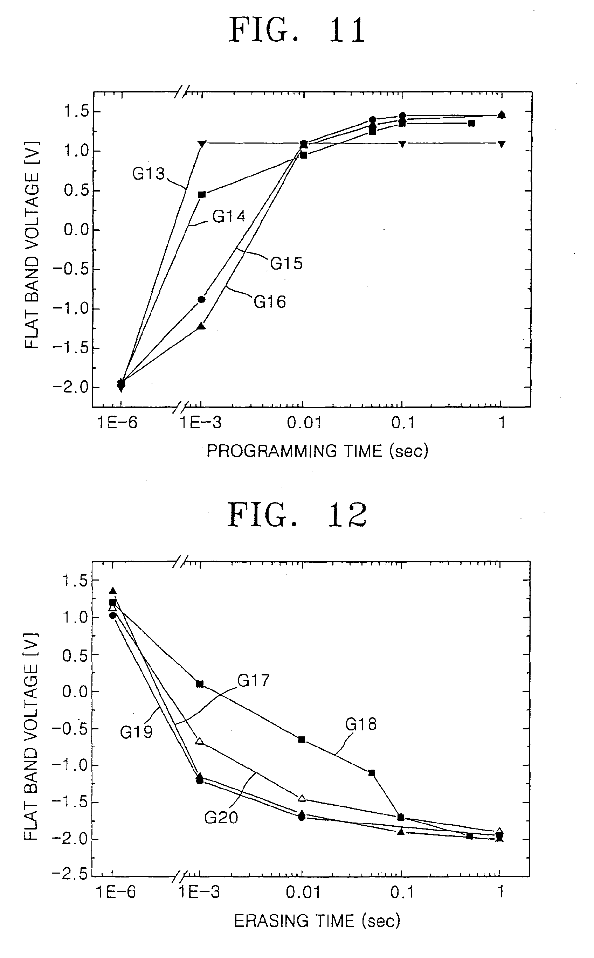

FIGS. 11 and 12 are showing the characteristics of data recording, that is, programming characteristics, and the characteristics of data erasing, respectively, of a nonvolatile semiconductor memory device of the present invention in comparison with the characteristics of the conventional art.

In FIG. 11, the graph G13 shows the variation of the flat band voltage according to the data recording time, that is, programming time when 8 volts of data recording voltage was applied to a nonvolatile semiconductor memory device having a gate stack with an OHA film (Oxide-Hafnium oxide-Aluminum oxide) according to an embodiment of the present invention. The graph G14 shows the flat band voltage according to the programming time when 10 volts of data recording voltage was applied to a conventional nonvolatile semiconductor memory device having a gate stack with an ONO film. The graph G15 shows the flat band voltage according to the programming time when 10 volts of data recording voltage was applied to a conventional nonvolatile semiconductor memory device having a gate stack with an ONA (Oxide-Nitride-Aluminum oxide) film. The graph G16 shows the flat band voltage according to the programming time when 8 volts of data recording voltage was applied to a conventional nonvolatile semiconductor memory device having a gate stack with an ONA film.

Referring to the graphs G13 through G16 in FIG. 11, it is observed that the gate stack having an OHA film (present invention) shows the shortest programming time but the largest amount of the shift of the flat band voltage in spite of applying a low operating voltage to the gate stack than the gate stack having an ONO film or an ONA film (conventional art). This means that the speed of data recording become faster at a lower voltage than the speed of data recording in the conventional art.

In FIG. 12, the graph G17 shows the variation of the flat band voltage according to the erasing time when an erasing voltage of -8 volts was applied to a nonvolatile semiconductor memory device having a gate stack with an OHA film according to an embodiment of the present invention. The graphs G18 and "•" G19 show the variation of the flat band voltage according to the erasing time when an erasing voltage of -10 volts was applied to a conventional nonvolatile semiconductor memory device having a gate stack with an ONO film and an ONA film, respectively. Also, the graph G20 shows the variation of the flat band voltage according to the erasing time when an erasing voltage of -8 volts was applied to a conventional nonvolatile semiconductor memory device having a gate stack with an ONA film.

Referring to the graphs G17 through G20 in FIG. 12, it is seen that in both cases, that is, when an erasing voltage of -8 volts was applied to the gate stack having an OHA film (the present invention) and when an erasing voltage of -10 volts was applied to the gate stack having an ONA film (conventional art), the resulted erasing characteristics are similar to each other. However, considering the lower erasing voltage in the former case, it can be said that the erasing characteristic of the former case is superior to the latter case. On the other hand, in the cases when erasing voltages of -10 volts and -8 volts were applied to the gate stack having an ONO film and an ONA film, respectively, the erasing characteristic of the conventional art shows much inferior to that of the present invention.

Now, the characteristics of energy bands of a nonvolatile semiconductor memory device according to an embodiment of the present invention will be described.

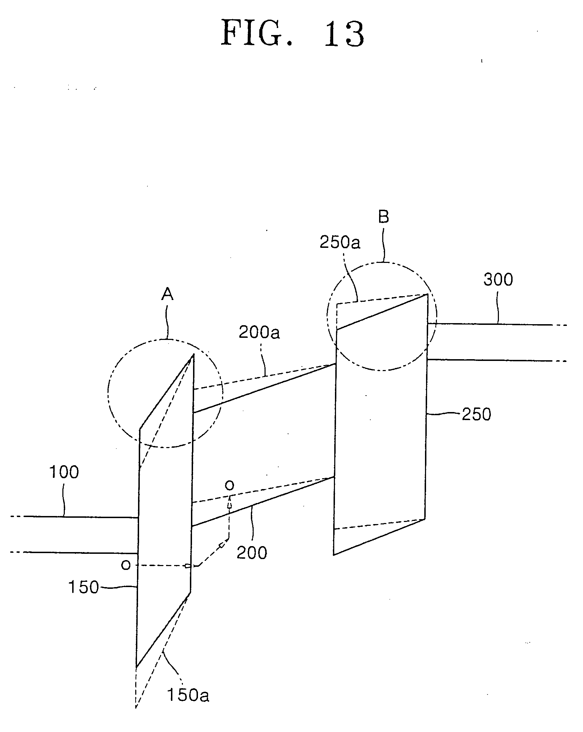

FIG. 13 shows the energy band of a nonvolatile semiconductor memory device having a gate stack according to the present invention, and for comparison purposes, that of a nonvolatile semiconductor memory device having a gate stack with an ONO film according to the conventional art.

Reference numerals 100 and 300 indicate the energy bands of a semiconductor substrate and a gate electrode, respectively, and numerals 150, 200, and 250 indicate the energy bands of an ONO film, that is, a lower silicon oxide film, a nitride film, and an upper silicon oxide film deposited sequentially between the semiconductor substrate and the gate electrode of the prior art, respectively. Reference numerals 150A, 200A, and 250A indicate the energy bands of an OHA film deposited sequentially between the semiconductor substrate and the gate electrode according to the present invention.

Referring to a circle A indicated in FIG. 13, the slope of the energy band 150A of the tunneling oxide film, that is, the silicon oxide film according to the present invention is steeper in comparison with the slope of the energy band 150 of the lower silicon oxide film. Accordingly, the tunneling speed of electrons through the silicon oxide film is faster, thereby increasing the programming speed.

At the same thickness of a silicon oxide film of the prior art and the corresponding film, that is, the tunneling oxide film of the present invention, as foregoing descriptions, the speed of the electrons passing through the tunneling oxide film according to the present invention is than that of the prior art. Therefore, the thickness of the tunneling oxide film of the present invention can be formed thicker than that of the lower silicon oxide film of the prior art within a limit not reducing the speed of electrons. Thus, the possibility that electrons trapped in the trapping material film leak can be reduced, thereby resulting in a superior retention characteristic of the present invention relative to the retention characteristic of the conventional art.

On the other hand, referring to circle B in FIG. 13, it is seen that the slope of the energy band 250 of the upper silicon oxide film of the prior art is steeper than the slope of the energy band 250A of the aluminum oxide film, which corresponds to the upper silicon oxide film, of the present invention. Accordingly, the back tunneling is reduced, and the erasing speed is faster in the present invention than in the conventional art.

Also, comparing the energy band 200 of a nitride film where the charge is trapped of the conventional art with the energy band 200A of a trapping material film of the present invention, that is, a hafnium oxide film which corresponds to the nitride film of the conventional art, the slope of the energy band 200 of the nitride film of the conventional art is steeper than the slope of the energy band 200A of the hafnium oxide film of the resent invention. Accordingly, the trap density of the trapping material film according to the present invention is increased compare to that of the nitride film of the conventional art, thereby increasing both the programming speed and erasing speed in comparison with the conventional art.

The following table summarizes the measurement results of the applied voltage distribution and the strength of electric field of a nonvolatile semiconductor memory device having an ONO film in the conventional art and having an OHA film, which has the same thickness as the ONO film, in the present invention when the same voltage, i.e., 10 volts, is applied to each film.

**(Table)**

| Film | Thickness (nm) | Voltage distribution (V) | Strength of electric field (MV/cm) |
|---|---|---|---|
| ONO | 18/60/45 | 1.91/3.31/4.78 | 10.62/5.52/10.62 |
| OHA | 18/60/45 | 3.81/2.48/3.71 | 21.16/4.13/8.25 |

Referring to the above table, it can be seen that the induced strength of an electric field of the lower silicon oxide film of the ONO film of the conventional art and that of the corresponding film, that is, the tunneling oxide film of the OHA film of the present invention is different. More specifically, the induced strength of the electric field of the lower silicon oxide film (hereinafter, a first strength of the electric field) of the conventional art is 10.62 MV/cm, while, that of the tunneling oxide film (hereinafter, a second strength of electric field) of the present invention is 21.16 MV/cm. That is, the second strength of electric field is more than double the first strength of electric field. Also, the induced strength of electric field of the upper silicon oxide film (hereinafter, a third strength of electric field) of the conventional art is 10.62 MV/cm, while, the induced strength of electric field of the aluminum oxide film (hereinafter, a fourth strength of electric field) of the present invention is 8.25 MV/cm, that is, the fourth strength of electric field is smaller than the third strength of electric field. Since the second strength of electric field is much larger than the first strength of electric field as depicted in FIG. 13, the slope of the energy band 150A of the tunneling oxide film in the present invention becomes bigger than that of the energy band 150 of the oxide film of the conventional art, accordingly, the tunneling of electrons through the oxide film of the present invention is much faster than that of the conventional art. Also, since the fourth strength of electric field is smaller than the third strength of electric field as depicted in FIG. 13, the slope of the energy band 250A of aluminum oxide film of the present invention become smaller than that of the energy band 250 of the upper silicon oxide film of the conventional art, therefore, as foregoing description, the back tunneling in the aluminum oxide film of the present invention takes place less than in the upper silicon oxide film of the conventional art.

The above results are natural in view of the dielectric constant distribution of the ONO film of the prior art and that of the OHA film of the present invention. That is, the dielectric constant ε is inversely proportional to the applied voltage V to the both end of the film like an ONO film or an OHA film, which can be expressed as follows:$\text{V = (Q x t) / (ε x Area)}$ where V is a voltage applied to the ONO or OHA films, Q is the amount of charge, t is a thickness of the ONO or OHA films, ε is a dielectric constant of the ONO or OHA films, and Area is the area of the gate electrode facing the substrate.

In the OHA film of the present invention, the tunneling oxide film has the lowest dielectric constant, the trapping material film, that is, hafnium oxide film has much higher dielectric constant than both of the tunneling oxide film and the aluminum oxide film, and the aluminum oxide film has average dielectric constant between the two. Therefore, when a predetermined voltage is applied to the OHA film, the largest voltage is induced in the tunneling oxide film, the next largest voltage is induced in the aluminum oxide film, and the lowest voltage is induced in the hafnium oxide film. Under this circumstance, the induced strength of electric field of the tunneling oxide film becomes the biggest since the tunneling oxide film has the thinnest thickness (1.8 nm), the induced strength of electric field of the aluminum oxide film is the second since it has medium thickness (4.5 nm), and the induced strength of electric field of the hafnium oxide film is the lowest because it has the thickest thickness (6 nm).

In the case of the ONO film of the conventional art, each film has a different induced voltage according to the dielectric constant of each film. The induced voltage become larger in the order from the lower silicon oxide film, nitride film, and the upper silicon oxide film, however, considering the thickness of each film, the induced strength of electric field of the lower silicon oxide film become equivalent to that of the upper silicon oxide film, and the nitride film has the lowest strength of electric field. However, in the ONO film of the conventional art, unlike the OHA film of the present invention, the dielectric constant difference between the films are not that big. For this reason, the induced voltage of the lower silicon oxide film of the conventional art is 1.91 volts, while, the induced voltage of the tunneling oxide film of the present invention is 3.81 volts which is two times larger than that of the conventional art. Considering that the lower silicon oxide film of the conventional art has the same thickness as the tunneling oxide film of the present invention, which is 1.8 nm, the difference in the induced strength of electric field between the two films is doubled as shown in the table above.

Next, the operations of the nonvolatile semiconductor memory device having the above characteristics according to the embodiment of the present invention will be described referring to the FIG. 2.

### Write

When a writing voltage Vg is applied to the gate electrode 48, a predetermined voltage Vd is applied to the drain region D. In this process, charges, that is, electrons are trapped in the first trapping material film 44, and the amount of shift of the flat band voltage is determined according to the amount of trapped electrons.

### Read

When a reading voltage Vg' is applied to the gate electrode 48, a predetermined voltage Vd' is also applied to the drain region D. In this process, it is assumed that data "1" is read when the current flow between a source S and a drain region D is more than a reference current, for example, 1 µA, and it is assumed that the data "0" is read when the current flow is less than the reference current.

Next, a method of manufacturing a nonvolatile semiconductor memory device according to the first embodiment of the present invention will be described.

More specifically, a tunneling oxide film 42, a first trapping material film 44, a first insulating film 46, and a gate electrode 48 are deposited on a substrate sequentially. The tunneling oxide film 42 is formed of a silicon oxide film which has a thickness of approximately 2∼4 nm. The first trapping material film 44 where the data are stored is preferably formed of a material film doped with a lanthanide approximately 1∼20%, preferably 10%, and having at least a higher dielectric constant than a nitride film, for example, an oxide film having a high dielectric constant selected from the group consisting of HfO₂, ZrO₂, Ta₂O₅, TiO₂, and Al₂O₃, more preferably, formed of HfO₂ film. When the first trapping material film 44 is formed of HfO₂ film, the thickness is preferably 2∼15 nm approximately. The first trapping material film 44 is formed by an ALD (atomic layer deposition), a sputtering, or a chemical vapor deposition.

Preferably, the lanthanide is selected from the group consisting of La, Ce, Pr, Nd, Sm, Eu, Gd, Tb, Dy, Ho, Er, Tm, Yb, and Lu, more preferably, it is Dy.

The first insulating film 46 is preferably formed of a material having a relatively big band gap, and having at least a higher dielectric constant than a nitride film, such as aluminum oxide film. Also, the aluminum oxide film may be formed using ALD.

When a second oxide film 52 is formed between the first trapping material film 44 and the first insulating film 46 as depicted in FIG. 3, the second oxide film is formed of an aluminum oxide film, and first insulating film 46 is formed of a film selected from the group consisting of HfO₂, ZrO₂, Ta₂O₅, and TiO₂. The thickness of the second oxide film 52 is approximately 0.5∼2 nm, and that of the first insulating film 46 is approximately 3∼20 nm.

Next, a photosensitive film pattern (not shown) defining the gate stack is formed on the gate electrode 48 as depicted in FIG. 2. The films from the gate electrode 48 to the tunneling oxide film 42 are etched sequentially using the photosensitive film pattern as a etch mask. Above etching is continued until the substrate 40 is exposed, and after completing the etching, the photosensitive film pattern is removed. Then, a gate stack is formed by depositing a tunneling oxide film 44, a first trapping material film 44, a first insulating film 46, and a gate electrode 48 sequentially on a predetermined region of a substrate as depicted in FIG. 2. Afterward, a conductive impurity doped on the semiconductor substrate 40, for example, an N-type impurity which is opposite to a P-type conductive impurity, is doped by ionic implantation with a predetermined depth on the entire surface of the semiconductor substrate where the gate stack is formed. Then, a source region S and drain region D are formed by a predetermined heat treatment, one end of the gate stack is contacting the source region and the other end of the gate stack contacts the drain region.

The method of manufacturing a nonvolatile semiconductor memory device according to the second through fourth embodiments of the present invention as depicted in FIGS. 3 through 5, comprises: forming a first and second oxide films 50 and 52 on and under the first trapping material film 44 according to the first embodiment of the present invention; forming a second trapping material film 54 and a second insulating film 56 between the first insulating film 46 and the gate electrode 48, and; forming an oxide films on and under the first and second trapping material films 44 and 54. The method of forming the additional films has already described in detail in the second through fourth embodiments of the present invention.

According to the foregoing descriptions, a nonvolatile semiconductor memory device according to the present invention provides an OHA film having a distribution of dielectric constant unlike that of the ONO film between a gate electrode and a substrate. In the OHA film, the "O" represents to a tunneling oxide film, "H" represents a hafnium film used as a trapping material film which corresponds to the nitride film in the ONO film, and "A" represents an aluminum oxide film used as a barrier film which corresponds to the upper silicon oxide film in the ONO film. The induced strength of electric field of the tunneling oxide film in the OHA film is much larger than the lower silicon oxide film in the ONO film. Therefore, the tunneling speed of the charge in the tunneling oxide film in the OHA film is much faster than in the lower silicon oxide film of the conventional art. This means that the operation speed of a memory device having OHA film is much faster than that of the ONO film of the prior art.

In the case of the present invention, since the tunneling speed of the charges is faster than the speed in the prior art, the thickness of the tunneling oxide film can be formed thicker than that of the lower silicon oxide film in the ONO film of the prior art under the condition that the tunneling speed of the charge is maintained as fast as in the OHA film. Accordingly, a nonvolatile semiconductor memory device according to the present invention has a much improved retention characteristics.

Also, in the OHA film of the present invention, since the trapping material film is doped with a lanthanide with a predetermined concentration, the trap site density of the trapping material film in the OHA film become much bigger. Therefore, the operation voltage of a nonvolatile semiconductor memory device according to the present invention becomes lower than that voltage of the prior art.

While this invention has been particularly shown and described with reference to embodiments thereof, it should not be construed as being limited to the embodiments set forth herein but as an exemplary. This invention may, however, be embodied in many different forms by those skilled in this art. For example, in the third and the fourth embodiments, the first trapping material film is a film doped with Dy, but the second trapping material film could be a nitride film. Also, an insulating material having a high dielectric constant other than the one described above can be used as the trapping material film. Likewise, since the present invention can be made in many different forms, the scope of the present invention shall be defined by appended claims not by the embodiments set forth herein.

## Claims

1. A nonvolatile semiconductor memory device comprising:
a semiconductor substrate having a source region and a drain region separated by a predetermined distance; and
a gate stack formed between the source region and the drain region on the substrate, one end of the gate stack contacting the source region and the other end of the gate stack contacting the drain region,
wherein the gate stack comprises:
a tunneling film;
a first trapping material film doped with a first predetermined doping impurity having a higher dielectric constant than a nitride film (Si₃N₄);
a first insulating film having a higher dielectric constant than a nitride film; and
a gate electrode, all of which are deposited sequentially.

2. The nonvolatile semiconductor memory device of claim 1, wherein the first insulating film is an aluminum oxide (Al₂O₃) film.

3. The nonvolatile semiconductor memory device of claim 1 or 2, further comprising a first oxide film between the tunneling film and the first trapping material film.

4. The nonvolatile semiconductor memory device of claim 2, wherein the first oxide film is an aluminum oxide (Al₂O₃) film.

5. The nonvolatile semiconductor memory device of claim 4, wherein the first insulating film is a film selected from the group consisting of HfO₂ film, ZrO₂ film, Ta₂O₅ film, and TiO₂ film.

6. The nonvolatile semiconductor memory device of any preceding claim, further comprising a second oxide film between the first trapping material film and the first insulating film.

7. The nonvolatile semiconductor memory device of any preceding claim, wherein the first predetermined impurity is a lanthanide including Dy.

8. The nonvolatile semiconductor memory device of claim 7, wherein the doping concentration of the lanthanide is 1∼20%.

9. The nonvolatile semiconductor memory device of any preceding claim, wherein the first trapping material film is a film selected from the group consisting of HfO₂, ZrO₂, Ta₂O₅, TiO₂, and Al₂O₃

10. The nonvolatile semiconductor memory device of any preceding claim, further comprising a second trapping material film doped with a predetermined second doping material and having a higher dielectric constant than the nitride film (Si₃N₄), and a second insulating film having a higher dielectric constant than the nitride film formed sequentially between the first insulating film and the gate electrode.

11. The nonvolatile semiconductor memory device of claim 10, wherein the second trapping material film is formed of a material selected from the group consisting of HfO₂, ZrO₂, Ta₂O₅, TiO₂, and Al₂O₃

12. The nonvolatile semiconductor memory device of claim 10 or 11, further comprising a first oxide film between the tunneling film and the first trapping material film.

13. The nonvolatile semiconductor memory device of claim 12, wherein the first oxide film is an aluminum oxide film.

14. The nonvolatile semiconductor memory device of either claim 10 or 11, further comprising a second oxide film between the first trapping material film and the first insulating film.

15. The nonvolatile semiconductor memory device of claim 14, wherein the second oxide film is an aluminum oxide film.

16. The nonvolatile semiconductor memory device of claim 14 or 15, wherein the first insulating film is a film selected from the group consisting of HfO₂ film, ZrO₂ film, Ta₂O₅ film, and TiO₂ film.

17. The nonvolatile semiconductor memory device of any of claims 10 to 16, further comprising a third oxide film between the first insulating film and the second trapping material film.

18. The nonvolatile semiconductor memory device of claim 17, wherein the third oxide film is an aluminum oxide film.

19. The nonvolatile semiconductor memory device of any of claims 10 to 18, further comprising a fourth oxide film between the second trapping material film and the second insulating film.

20. The nonvolatile semiconductor memory device of claim 19, wherein the fourth oxide film is an aluminum oxide film.

21. The nonvolatile semiconductor memory device of any one of claims 10, 16, 17, and 18, wherein the second insulating film is a film selected from the group consisting of HfO₂ film, ZrO₂ film, Ta₂O₅ film, TiO₂ film, and Al₂O₃ film.

22. The nonvolatile semiconductor memory device of any of claims 10 to 21, wherein the predetermined first impurity is a lanthanide including Dy.

23. The nonvolatile semiconductor memory device of claim 22,
wherein the doping concentration of the lanthanide is 1∼20%.

24. The nonvolatile semiconductor memory device of any of claims 10 to 23, wherein the predetermined second impurity is a lanthanide including Dy.

25. The nonvolatile semiconductor memory device of claim 24, wherein the doping concentration of the lanthanide is 1∼20%.

26. A method of manufacturing a nonvolatile semiconductor memory device, the method comprising:
forming a tunneling oxide film, a first trapping material film doped with a first predetermined impurity and having a higher dielectric constant than that of the nitride film, a first insulating film having a higher dielectric constant than that of the nitride film, and a gate electrode, all of which are deposited sequentially on a semiconductor substrate;
forming a photosensitive film pattern defining a gate region on the gate electrode;
forming a gate stack by sequentially etching the gate electrode, the first insulating film, the first trapping material film, and the tunneling oxide film around the photosensitive film pattern;
removing the photosensitive film pattern; and
forming a source and drain region around the gate stack on the semiconductor substrate.

27. The method of claim 26, further comprising forming an oxide film either on or under the first trapping material film.

28. The method of claim 26 or 27, further comprising forming a second trapping material film doped with a predetermined a second impurity, and a second insulating film, sequentially, between the first insulating film and the gate electrode.

29. The method of claim 28, further comprising forming a oxide film either on or under the first trapping material film, and either on or under the second trapping material film.

30. The method of claims either 28 or 29, wherein the second trapping material film is a film selected from the group consisting of HfO₂ film, ZrO₂ film, Ta₂O₅ film, TiO₂ film, and Al₂O₃ film.

31. The method of claim 28, wherein the second insulating film is a film selected from the group consisting of HfO₂ film, ZrO₂ film, Ta₂O₅ film, and TiO₂ film.

32. The method of any one of claims 26 through 31, wherein the first trapping material film is a film selected from the group consisting of HfO₂ film, ZrO₂ film, Ta₂O₅ film, TiO₂ film and Al₂O₃.

33. The method of any one of claims 26 through 32, wherein the first insulating film is a film selected from the group consisting of HfO₂ film, ZrO₂ film, Ta₂O₅ film, and TiO₂ film.

34. The method of claims either 27 or 29, wherein the oxide film is an aluminum oxide film.

35. The method of any of claims 26 to 34, wherein the first impurity is a lanthanide including Dy, and the doping concentration is 1∼20%.
